# EUROPEAN PATENT APPLICATION

(11) **EP 3 683 839 A1**
(43) Date of publication of application: **22.07.2020**
(21) Application number: 18856212.8
(22) Date of filing: 13.09.2018
(51) Int. Cl.: H01L 27/32, H01L 21/77

(54) **DISPLAY PANEL AND MANUFACTURING METHOD THEREFOR, AND DISPLAY APPARATUS**

(30) Priority: 15.09.2017 CN 201710840388
(71) Applicant: BOE TECHNOLOGY GROUP CO., LTD., Beijing 100015 (CN); Chengdu BOE Optoelectronics Technology Co., Ltd., Chengdu, Sichuan 611731 (CN)
(72) Inventor: HUANG, Weiyun, Beijing 100176 (CN); CHENG, Tianyi, Beijing 100176 (CN)
(74) Representative: Klunker IP Patentanwälte PartG mbB
(86) International application number: PCT/CN2018/105454
(87) International publication number: WO 2019/052502

(57) **Abstract**

Disclosed are a display panel and a manufacturing method therefor, and a display apparatus. The display panel comprises: a base substrate (101); a pixel unit arranged on the base substrate (101), the pixel unit comprising a drive circuit layer (102); and a patterned metal layer located between the drive circuit layer (102) and the base substrate (101), wherein the metal layer comprises at least a first part (103A) for connecting a power supply voltage signal of the display panel. The metal layer can reduce the transmission resistance for a power supply voltage signal, thereby reducing a voltage drop generated during the transmission of the power supply voltage signal, so that the display brightness at each location of the display panel is more accurate.

## Description

### CROSS-REFERENCE TO RELATED APPLICATION

The present application claims benefits of priority of the Chinese Patent Application No. 201710840388.X, filed on September 15, 2017, the disclosure of which is incorporated herein by reference in its entirety as part of the present application.

### TECHNICAL FIELD

Embodiments of the present disclosure relate to a display panel and a manufacturing method thereof, and a display device.

### BACKGROUND

Due to its advantages of self illumination, quick response, a wide viewing angle, high brightness, bright color, light weight, or the like, an organic light emitting display panel becomes an important display technology. An organic light emitting display panel usually includes a plurality of pixel units, each of which includes one OLED (Organic Light Emitting Diode), The OLED usually includes an anode, a cathode and an organic functional layer located therebetween, for example, a light emitting layer. When an appropriate voltage is applied to the anode and cathode of the OLED, holes injected from the anode and electrons injected from the cathode are combined in the light emitting layer and then excited to generate light, to implement display.

### SUMMARY

At least one embodiment provides a display panel, comprising: a base substrate; pixel units on the base substrate, each of the pixel units comprising a drive circuit layer; a patterned metal layer between the drive circuit layer and the base substrate, the metal layer comprising a first part at least configured to connect the power voltage signal of the display panel.

For example, in the display panel provided by at least one embodiment of the present disclosure, the drive circuit layer comprises a power line configured to provide a power voltage signal for the pixel units, the first part being connected with the power line in parallel.

For example, in the display panel provided by at least one embodiment of the present disclosure, the power line comprises a part of the source-drain conducting layer.

For example, in the display panel provided by at least one embodiment of the present disclosure, the drive circuit layer comprises a capacitor and a thin film transistor, the capacitor comprising a first electrode and a second electrode, the metal layer further comprising a second part, the first electrode being located between the second electrode and the second part, an orthographic projection of the first electrode on the base substrate being at least partially overlapped with that of the second part on the base substrate, and the second electrode being electrically connected with the second part of the metal layer.

For example, in the display panel provided by at least one embodiment of the present disclosure, the first part is electrically connected with the second part.

For example, in the display panel provided by at least one embodiment of the present disclosure, the metal layer further comprises a third part, an orthographic projection of the third electrode on the base substrate being at least partially overlapped with that of the active layer of the thin film transistor on the base substrate.

For example, in the display panel provided by at least one embodiment of the present disclosure, the display panel comprises a display area and a peripheral area, the first part of the metal layer being located in the display area, and the metal layer further comprising a fourth part located in the peripheral area, and configured to transfer signals.

For example, in the display panel provided by at least one embodiment of the present disclosure, the display panel further comprises a barrier layer and a buffer layer between the base substrate and the drive circuit layer, the metal layer being provided between the barrier layer and the buffer layer.

At least one embodiment of the present disclosure provides a method for manufacturing a display panel, comprising: forming a patterned metal layer on the base substrate; and forming pixel units on the metal layer, each of the pixel units comprising a drive circuit layer, and the metal layer comprising a first part at least for connecting a power voltage signal of the display panel.

For example, in the method for manufacturing the display panel provided by at least one embodiment of the present disclosure, the drive circuit layer comprises a power line for providing a power voltage signal for the pixel units, the first part being formed to be connected with the power line in parallel.

For example, in the method for manufacturing the display panel provided by at least one embodiment of the present disclosure, a capacitor and a thin film transistor are formed in the drive circuit layer; the capacitor comprising a first electrode and a second electrode, the metal layer further comprising a second part, the first electrode being formed between the second electrode and the second part, an orthographic projection of the first electrode on the base substrate being at least partially overlapped with that of the second part on the base substrate, and the second electrode being formed to be electrically connected with the second part of the metal layer.

For example, in the method for manufacturing the display panel provided by at least one embodiment of the present disclosure, the first part is formed to be electrically connected with the second part.

For example, in the method for manufacturing the display panel provided by at least one embodiment of the present disclosure, the metal layer further comprises a third part, an orthographic projection of the third part on the base substrate being at least partially overlapped with that of the active layer of the thin film transistor on the base substrate.

For example, in the method for manufacturing the display panel provided by at least one embodiment of the present disclosure, the display panel comprises a display area and a peripheral area, the first part of the metal layer being formed in the display area, and the metal layer further comprising a fourth part formed in the peripheral area, the fourth part being used for transferring signals.

For example, the method for manufacturing the display panel provided by at least one embodiment of the present disclosure further comprises forming a barrier layer and a buffer layer between the base substrate and the drive circuit layer, the metal layer being formed between the barrier layer and the buffer layer.

For example, in the method for manufacturing the display panel provided by at least one embodiment of the present disclosure, a first via hole is formed in at least the drive circuit layer on the first part, to allow the first part to be connected with the power line through the first via hole.

For example, in the method for manufacturing the display panel provided by at least one embodiment of the present disclosure, a second via hole is formed in at least the drive circuit layer on the fourth part, to allow the fourth part to be connected with the power line through the second via hole.

For example, in the method for manufacturing the display panel provided by at least one embodiment of the present disclosure, the first via hole and the second via hole are formed by a same mask.

For example, in the method for manufacturing the display panel provided by at least one embodiment of the present disclosure, the first part, the second part, the third part and the fourth part are formed by a same mask.

At least one embodiment of the present disclosure provides a display device, comprising any of the display panels.

### BRIEF DESCRIPTION OF THE DRAWINGS

In order to clearly illustrate the technical solution of the embodiments of the disclosure, the drawings of the embodiments will be briefly described in the following. It is apparent that the described drawings are only related to some embodiments of the disclosure and are not limits to the disclosure.
Fig. 1A is a schematic diagram of a 2T1C pixel circuit;
Fig. 1B is a schematic diagram of another 2T1C pixel circuit;
Fig. 2 is a first schematic diagram of a display panel according to an embodiment of the present disclosure;
Figs. 3A-3C are second schematic diagrams of a display panel according to an embodiment of the present disclosure;
Fig. 4 is flow chart of a process for manufacturing a display panel according to an embodiment of the present disclosure; and
Figs. 5A-5C and Figs. 6 to 11 are sectional views of the display panel according to an embodiment of the present disclosure during the manufacturing process.

### DETAILED DESCRIPTION

In order to make objects, technical solutions and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, one of ordinary skill in the art can obtain other embodiment(s) without any creative work, which shall be within the scope of the disclosure.

Unless otherwise defined, all the technical and scientific terms used herein have the same meanings as commonly understood by one of ordinary skill in the art to which the present disclosure belongs. The terms "first," "second," or the like, which are used in the present application for disclosure, are not intended to indicate any sequence, amount or importance, but to distinguish various components. The terms "comprise;" "comprising," "include," "including," or the like, are intended to specify that the elements or the objects stated before these terms encompass the elements or the objects and equivalents thereof listed after these terms, but do not preclude other elements or objects. The terms "connect/couple", "connected/coupled", or the like, are not limited to a physical connection or mechanical connection, but may also include an electrical connection, directly or indirectly. "On," "under," "right," "left" or the like are only used to indicate relative position relationship, and when the position of the object which is described is changed, the relative position relationship may be changed accordingly.

A pixel circuit in an OLED display panel usually is matrix-driven, and is divided into active matrix-driven and passive matrix-driven according to whether a switch device is provided in each pixel unit, or not. In the active matrix OLED (AMOLED), generally, a group of thin film transistor and storage capacitor is integrated in the pixel circuit of each pixel unit. Through the drive control over the thin film transistor and the storage capacitor, the control over the current flowing through the OLED is implemented, to allow the OLED to emit light as needed.

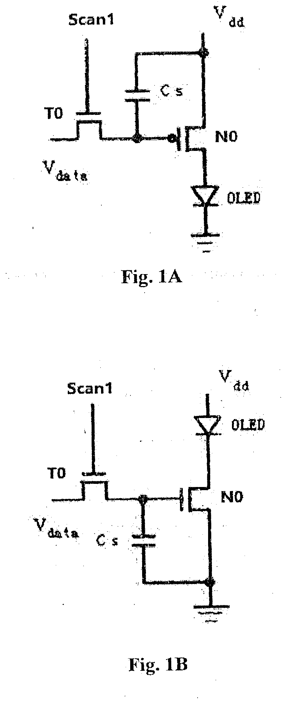

In the AMOLED display panel, as a basic pixel circuit, a 2T1C pixel circuit is usually used, i.e., two TFTs and one storage capacitor are used to implement the basic function of driving the OLED to emit light. Figs. 1A and 1B are schematic diagrams of two different 2T1C pixel circuits, respectively.

As shown in Fig. 1A, a 2T1C pixel circuit includes a switch transistor T0, a drive transistor NO and a storage capacitor Cs. For example, a gate electrode of the switch transistor TO is connected with a scan line to receive a scan signal Scan1. For example, a source electrode is connected with a data line to receive a data signal Vdata, and a drain electrode is connected to a gate of a drive transistor N0; a source electrode of the drive transistor N0 is connected to a first voltage terminal to receive a first voltage Vdd (a high voltage), a drain electrode is connected to a positive terminal of the OLED; one terminal of the storage capacitor Cs is connected to the drain electrode of the switch transistor T0 and the gate electrode of the drive transistor N0, the other terminal is connected to the source electrode of the drive transistor N0 and a power line, so as to be connected to the first voltage terminal Vdd; a negative terminal of the OLED is connected to a second voltage terminal to receive a second voltage Vss (a low voltage, for example, a grounding voltage). The 2T1C pixel circuit is driven by controlling a brightness (gray scale) of the pixel through two TFTs and one storage capacitor Cs. When the scan signal Scan1 is applied via the scan line to switch on the switch transistor T0, a data-driven circuit charges the storage capacitor Cs via the switch transistor T0 through the data signal Vdata fed by the data line, so as to store the data signal Vdata into the storage capacitor Cs. The stored data signal Vdata controls the degree of conduction of the drive transistor N0, so as to control the current flowing through the drive transistor to drive the OLED to emit light, i.e., the current decides the gray scale of the pixel emitting light. In the 2T1C pixel circuit shown in Fig. 1A, the switch transistor TO is of N type, and the drive transistor N0 is of P type.

As shown in Fig. 1B, another 2T1C pixel circuit also includes a switch transistor T0, a drive transistor N0 and a storage capacitor Cs, with a slight change in its connection, and the drive transistor N0 is of N type. The pixel circuit in Fig. 1B differs from that in Fig. 1A in that the positive terminal of the OLED is connected to the power line, to being connected to the first voltage terminal Vdd, so as to receive the first voltage Vdd (a high voltage), and the negative terminal is connected to the drain electrode of the drive transistor N0, and the source electrode of the drive transistor N0 is connected to the second voltage terminal, to receive the second voltage Vss (a low voltage, for example, a grounding voltage). One terminal of the storage capacitor Cs is connected to the drain electrode of the switch transistor TO and the gate of the drive transistor N0, and the other terminal is connected to the source electrode of the drive transistor N0 and the second voltage terminal. The 2T1C pixel circuit works substantially in the same way as the 2T1C pixel circuit shown in Fig. 1A, no description is repeated herein.

In addition, for the pixel circuit shown in Figs. 1A and 1B, the switch transistor TO is not limited to the N type, but may be of a P type, as long as a polarity of the scan signal provided by a scan control terminal Scan1 in an ON or OFF state is controlled to change correspondingly. In addition, industrially, other pixel circuits with a compensation function are arranged additionally beside the above-mentioned basic 2T1C pixel circuit. The compensation function may be implemented by a voltage compensation, a current compensation or a combined compensation, or by an internal compensation, an external compensation, or the like. The pixel circuit with the compensation function may be 4T1C, 4T2C, 7T1C, or the like, for example, without detailed description herein.

Currently, the organic light emitting display panel is developed towards a big screen, but the display uniformity may tend to degrade with the increased size. The bigger the size of the display panel is, the longer the transfer path of a signal (e.g., a power voltage of each pixel unit of the display panel) is, and the greater the resistance the signal transfer bears. Therefore, the display uniformity of the display panel is getting worse due to the great difference of signals at different positions of the display panel.

In order to reduce a transfer resistance of a power voltage signal in the display panel, for example, the display panel may be provided with two source-drain conducting layers (i.e., including a conducting layer of a source-drain electrode of the thin film transistor), to form the power line. In this way, the display panel of the power line with one source-drain conducting layer has a less transfer resistance of the power voltage signal, so that a resistance drop of the power voltage signal is reduced, and the difference in the power voltage signal at various positions of the display panel is further reduced, which enables the display panel to have better display uniformity. However, in order to add one additional source-drain conducting layer in the display panel, an insulating layer is required correspondingly. Therefore, in the process of manufacturing the display panel, at least two more photolithographic processes are needed to form the additional source-drain conducting layer, such that the manufacturing process of the display panel is more complicated and has higher costs.

At least one embodiment of the present disclosure provides a display panel, including: a base substrate; pixel units on the base substrate, each pixel unit including a drive circuit layer; a patterned metal layer located between the drive circuit layer and the base substrate, the metal layer including a first part at least for connecting the power voltage signal of the display panel.

At least one embodiment of the present disclosure provides a method for manufacturing a display panel, including: forming a patterned metal layer on a base substrate; forming pixel units on the metal layer, each pixel unit including a drive circuit layer. The metal layer includes a first part at least for connecting the power voltage signal of the display panel.

At least one embodiment of the present disclosure provides a display device, including a display panel, the display panel including: a base substrate; pixel units on the base substrate, each pixel unit including a drive circuit layer; a patterned metal layer located between the drive circuit layer and the base substrate, the metal layer including a first part at least for connecting the power voltage signal of the display panel.

The display panel and manufacturing method thereof according to the present disclosure will be explained below by several embodiments.

At least one embodiment of the present disclosure provides a display panel, including a plurality of pixel units, each of which includes a light emitting diode and its corresponding pixel circuit. The pixel circuit, for example, may be any one of the above-mentioned pixel circuits. The following description is made by taking one pole of the storage capacitor in the pixel circuit connected with the power voltage terminal Vdd via the power line as an example, but it is not limited in the present embodiment.

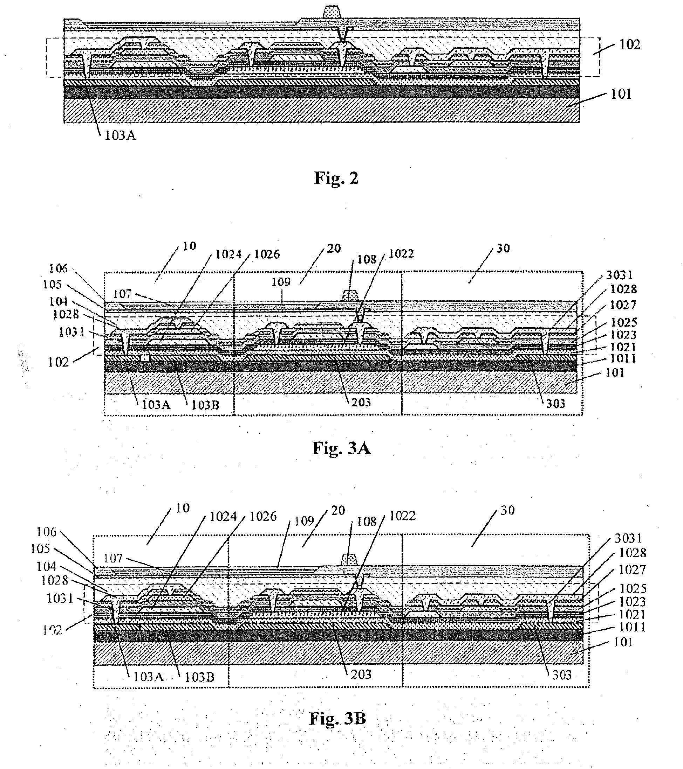

As shown in Fig. 2, the display panel includes: a base substrate 101; a pixel unit on the base substrate 101, the pixel unit including a drive circuit layer 102; a patterned metal layer located between the drive circuit layer 102 and the base substrate 101, the metal layer including a first part 103A at least for connecting the power voltage signal of the display panel.

In the present embodiment, as shown in Figs. 3A-3C, for example, the display panel may include a display area and a peripheral area. The display area includes a pixel unit for display, and the peripheral area includes various signal lines. For example, the display area includes a first area 10 and a second area 20, and the peripheral area includes a third area 30.

In the present embodiment, for example, the drive circuit layer 102 may have a plurality of thin film transistors, capacitors, gate lines, data lines, a power line, or the like for driving the display panel. The plurality of thin film transistors may include a drive transistor, a switch transistor, or the like. The gate lines, the data lines, the power line, or the like extend into the peripheral area from the display area, and are electrically connected with a gate drive circuit, a data drive circuit, a power voltage terminal, or the like. In the present embodiment, for example, the power line may include one part of the source-drain conducting layer (described in detail later); for example, the power line may include one part of the gate conducting layer and one part of the source-drain conducting layer which are located on different layers and are electrically connected with each other, and the power line may be directly or indirectly connected to the power voltage terminal.

For example, as shown in Figs. 3A-3C, in the present embodiment, the drive circuit layer 102 may include functional layers, such as an active layer 1022, a first gate insulating layer 1023, a first gate conducting layer 1024, a second gate insulating layer 1025, a second gate conducting layer 1026, an insulating layer 1027 and a source-drain conducting layer 1028, or the like. These structural or functional layers form a capacitor located in the first area 10, the thin film transistor located in the second area 20, peripheral signal lines located in the third area 30, or the like. The thin film transistor may be a drive transistor, for example.

In an example of the present embodiment, the display panel may further include a barrier layer 1011 and a buffer layer 1021 located between the base substrate 101 and the drive circuit layer 102, and the patterned metal layer may be located between the barrier layer 1011 and the buffer layer 1021, for example. The base substrate 10 is a glass substrate, a plastic substrate, or the like. The barrier layer 1011 is formed to prevent property degradation of the thin film transistor, for example, due to the diffusion of impurities or harmful ions in the base substrate into the drive circuit layer. The buffer layer 1021 covers the metal layer.

For example, in the present embodiment, the first gate conducting layer 1024, the second gate insulating layer 1025 and the second gate conducting layer 1026 located in the first area 10 are overlapped to form a first capacitor; at this point, the first gate conducting layer 1024 acts as a first electrode of the first capacitor, the second gate insulating layer 1025 acts as a medium of the first capacitor, and the second gate conducting layer 1026 acts as a second electrode of the first capacitor. In addition, the metal layer may further include a second part 103B which faces at least partially the first electrode (i.e., the first gate conducting layer 1024) of the first capacitor; for example, an orthographic projection of the first electrode on the base substrate 101 is at least partially overlapped with that of the second part 10313 on the base substrate 101.

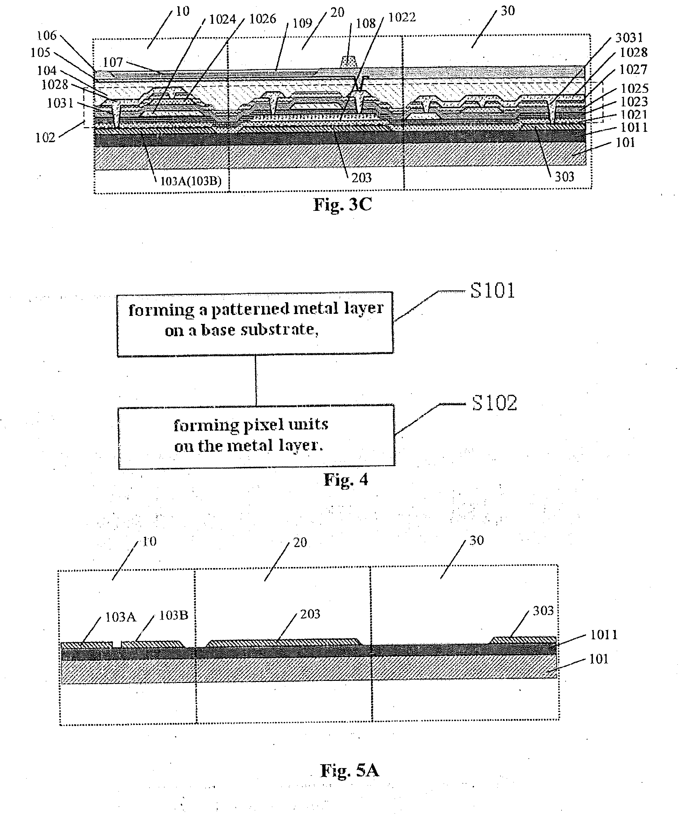

As shown in Fig. 3A, the second part 103B and the first part 103Amay be two independent parts. As shown in Fig. 3B, the second part 103B may be electrically connected with the first part 103A, for example. As shown in Fig. 3C, the second part 103B and the first part 103A may also be a same and continuous part, i.e., the second part 103B and the first part 103A are the same metal layer structure.

In an example of the present embodiment, the second part 103B of the metal layer, the buffer layer 1021, the first gate insulating layer 1023 and the first gate conducting layer 1024 may form the second capacitor. The buffer layer 1021 and the first gate insulating layer 1023 act as a medium of the second capacitor, and the second part 103B and the first gate conducting layer 1024 may act as the first electrode and the second electrode of the second capacitor respectively. At this point, for example, the second electrode of the first capacitor may be electrically connected with the second part 103B, so that the first capacitor is connected with the second capacitor in parallel. In this way, the second part 103B of the metal layer may further increase a total capacitance of the capacitor of the pixel unit. The increase of the capacitance may realize more sufficient power supply volume for each pixel unit of the display panel, to avoid blinking display of the pixel unit, and improve the display quality of the display panel. In addition, the structure of the first capacitor and the second capacitor which are connected in parallel may increase the capacitance per unit area of the capacitor, so as to reduce the space where the capacitor occupies for a given capacitance, contributing to the design of a high resolution of the display panel.

In the present embodiment, the first part 103A and the second part 103B of the metal layer located in the first area 10 may be two independent parts, or be a same metal layer structure formed integrally. When the first part 103A and the second part 103B are the same metal layer structure, the structure may be connected with the power voltage signal and form a capacitor together with other functional layers.

In the present embodiment, for example, the source-drain conducting layer 1028 in the first area 10 may be connected with the power voltage signal, i.e., as the power line which provides the power voltage signal for the pixel unit, and the first part 103A of the metal layer may be electrically connected with the power line, i.e., the source-drain conducting layer 1028, via at least one first via hole 1031. In this way, the first part 103A and the source-drain conducting layer 1028 are connected in parallel, for example, to provide the power voltage signal for the pixel unit. In this way, in the present embodiment, the arrangement of the first part 103A can reduce the transfer resistance of the power voltage signal, and reduce the voltage drop generated when the power voltage signal is transferred, and further reduce the difference in the power voltage signal at various positions of the display panel, achieving the technical effects of improving display uniformity of the display panel.

In the present embodiment, the active layer 1022, the first gate insulating layer 1023, the first gate conducting layer 1024 (as the gate electrode of the thin film transistor), the second gate insulating layer 1025, the insulating layer 1027 and the source-drain conducting layer 1028 (including the source electrode and drain electrode of the thin film transistor) located in the second area 20 form a thin film transistor. The source electrode and drain electrode of the thin film transistor may be connected with the power line and the pixel electrode respectively, for driving the organic light emitting diode to emit light.

In the present embodiment, the metal layer may further include a third part 203. For example, the orthographic projection of the third part 203 on the base substrate 101 is at least partially overlapped with that of the active layer 1022 of the thin film transistor on the base substrate. For example, the orthographic projection of the third part 203 of the metal layer on the base substrate 101 is at least partially overlapped with that of a channel region of the active, layer 1022 (the part in the active layer corresponding to the gate electrode is the channel region) on the base substrate, for example, overlapped with each other completely. For another example, the orthographic projection of the third part 203 on the base substrate is completely overlapped with that of the active layer 1022 on the base substrate 101. The third part 203 of the metal layer may block external rays of light, so as to avoid harmful effects of the external rays of light on the channel region of the thin film transistor, for example, to avoid the increase in a leakage current of the thin film transistor due to incident rays of light.

In the present embodiment, the first gate conducting layer 1024, the second gate conducting layer 1026 and the source-drain conducting layer 1028 located in the third area 30 may form a peripheral signal line, for example, gate lines, data lines, a power line, or the like. For example, the metal layer may further include a fourth part located in the peripheral area, e.g., the metal layer includes a fourth part 303 located in the third area 30 for transferring signals. For example, the fourth part 303 may be electrically connected with the source-drain conducting layer 1028, the first gate conducting layer 1024 and the second gate conducting layer 1026 located in the third area 30 via at least one second via hole 3031. In this way, the designed structure may be used for forming the power line. Since the formed power line may consist of parts on three different layers, and the parts may be electrically connected one another via at least one via hole (for example, parallel connection), the resistance of the power line can be reduced. In this way, when the source-drain conducting layer 1028 located in the third are 30 is connected with the power voltage signal, the arrangement of the fourth part can also reduce the transfer resistance of the power voltage signal, and reduce the difference in the power voltage signal at various positions of the display panel, achieving the technical effects of improving display uniformity of the display panel.

In other examples of the present embodiment, the fourth part 303 of the metal layer may further be connected with other signals, for example, a clock signal (CLK), a reset signal (INI), a gate high voltage (VGH), a gate low voltage (VGL), or the like. In this way, the fourth part 303 of the metal layer may take full advantage of the space of the peripheral area, contributing the design of a narrow bezel of the display panel.

In the present embodiment, the metal layer may be made of an appropriate material, such as titanium, titanium alloy, aluminum, aluminum alloy, molybdenum, molybdenum alloy, copper, copper alloy, or their combination. For example, the metal layer may have a titanium/aluminum/titanium structure of three layers, a titanium/aluminum structure of double layers, or the like, but it is not limited in the present embodiment.

In the present embodiment, the display panel may further include other functional structures, such as a planarization layer 104, a pixel electrode layer 105, a pixel definition layer 106, a light-emitting layer 107, a common electrode 109, a spacer 108, and no description is repeated in the present embodiment. The light-emitting layer 107 is sandwiched between the pixel electrode layer 105 and the common electrode 109, to form the organic light emitting diode.

The patterned metal layer located between the drive circuit layer and the base substrate of the display panel according to the present embodiment may include a plurality of parts, where at least the first part may be used for connecting the power voltage signal of the display panel, so it can reduce the transfer resistance of the power voltage signal, and reduce the voltage drop generated when the power voltage signal is transferred, and further reduce the difference in the power voltage signal at various positions of the display panel, which enables the display brightness at each position of the display panel to be more accurate, achieving the technical effects of improving display uniformity of the display panel. For example, for a display panel with large size, the metal layer can effectively improve the display uniformity of the display panel.

In the present embodiment, the second part of the metal layer may be combined with the first capacitor of the display panel to form the second capacitor, so as to increase a total capacitance of the capacitor of the pixel unit. The increase in the capacitance may realize more sufficient power supply volume for each pixel unit of the display panel, avoiding blinking display of the pixel unit, and improving the display quality of the display panel. In addition, the parallel connection of the first capacitor and the second capacitor may increase the capacitance per unit area of the capacitor, so as to reduce the space where the capacitor occupies for a given capacitance, contributing to the design of high resolution of the display panel.

In the present embodiment, the third part of the metal layer is arranged corresponding to the thin film transistor, for effectively protecting the channel region of the thin film transistor, and avoiding harmful effects due to the external rays of light incident on the channel region. The fourth part of the metal layer is located in the peripheral area, for connecting the power voltage signal of the display panel to improve the display uniformity of the display panel, or for connecting other signals, for taking full advantage of the space of the peripheral area, and contributing to the design of a narrow bezel of the display panel.

In addition, in the present embodiment, various parts of the metal layer are located in the same layer, so these parts can be formed in a same process step, which can simplify the manufacture process of the display panel and reduce costs.

At least one embodiment of the present disclosure provides a method for manufacturing a display panel, and the display panel is the above-mentioned display panel, for example. As shown in Fig. 4, the method includes steps S101 to S102.

In step S101, a patterned metal layer is formed on the base substrate.

In the present embodiment, the display panel may include a display area and a peripheral area. The display area may include a first area 10 and a second area 20, and the peripheral area may include a third area 30.

In the present embodiment, as shown in Fig. 5A, firstly, the patterned metal layer is formed on the base substrate 101. The metal layer may include a first part 103A at least for connecting the power voltage signal of the display panel. For example, the first part 103A may be formed in the first area 10, and the first part 103A may be connected with the later-formed power line of the display panel, for reducing the transfer resistance of the power voltage signal, reducing the voltage drop generated when the power voltage signal is transferred, further reducing the difference in the power voltage signal at various positions of the display panel, and achieving the technical effects of improving display uniformity of the display panel.

For example, the metal layer may further include a second part 103B formed in the first area 10. The second part 103B may be formed at the position where a capacitor is to be formed, such that the orthographic projection of the first electrode of the capacitor (near the second part) on the base substrate 101 is at least partially overlapped with that of the second part 103B on the base substrate 101, to enable the second part 103B to be combined with the capacitor to be formed subsequentially, and increase its capacitance.

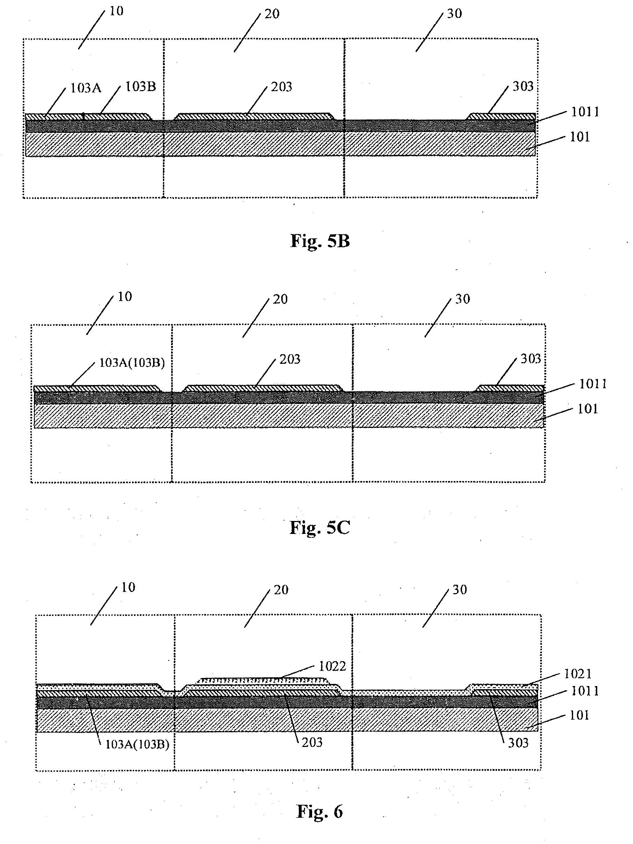

In the present embodiment, as shown in Fig. 5A, the first part 103A and the second part 103B may be two independent parts which are not connected; or, as shown in Fig. 5B, the first part 103A and the second part 103B may be electrically connected with each other; or as shown in Fig. 5C, the first part 103A and the second part 103B may be the same metal layer structure. When the first part 103A and the second part 103B are the same metal layer structure, the structure can be connected/coupled with the power voltage signal, and may also form a capacitor together with other functional layers.

In the present embodiment, the metal layer may further include a third part 203 formed in the second area 20. The third part 203 may be formed at a position of the thin film transistor to be formed for driving the display panel to emit light, for example, the position facing the orthographic projection of the active layer in the thin film transistor or the channel region in the active layer on the base substrate 1, such that the orthographic projection of the third part 203 on the base substrate 101 is at least partially overlapped with that of the active layer 1022 of the thin film transistor on the base substrate, to block external rays of light by the third part 203, so as to avoid harmful effect of the external rays of light on the channel region of the thin film transistor, for example, to avoid an increase in the leakage current of the thin film transistor due to incident rays of light.

In the present embodiment, the metal layer may further include for example, a fourth part 303 formed in the third area 30, for transferring signals. For example, the fourth part 303 may also be connected with the power voltage signal, so as to reduce the transfer resistance of the power voltage signal, and the difference in the power voltage signal at various positions of the display panel, and improve display uniformity of the display panel.

In other examples of the present embodiment, the fourth part 303 of the metal layer may further be connected with other signal, such as a clock signal (CLK), a reset signal (INI), a gate high voltage (VGH), a gate low voltage (VGL), or the like. In this way, the fourth part 303 may take full advantage of the space of the peripheral area, contributing to the design of a narrow bezel of the display panel.

In the present embodiment, the first part 103A, the second part 103B, the third part 203 and the fourth part 303 of the metal layer may be formed by performing a single patterning process (for example, a photolithography process) on the same metal thin film layer through a same mask. In this way, the manufacture process of the display panel is simplified.

In the present embodiment, the metal layer may be made of an appropriate material, such as titanium, titanium alloy, aluminum, aluminum alloy, molybdenum, molybdenum alloy, copper and copper alloy, or their combination. For example, the metal layer may have a titanium/aluminum/titanium structure of three layers, a titanium/aluminum structure of double layers, or the like, but it is not limited in the present embodiment.

In the present embodiment, before the patterned metal layer is formed on the base substrate 101, for example, a barrier layer 1011 may be formed, and then a metal layer is formed on the barrier layer 1011 for protecting the metal layer. The barrier layer 1011 may be made of an appropriate material, such as silicon nitride, silicon oxide, silicon oxynitride, or the like, and is not limited in the present embodiment.

In step S 102, a pixel unit is formed on the metal layer.

In the present embodiment, after the metal layer is formed, pixel units may be formed on the metal layer, and each pixel unit may include a drive circuit layer and an organic light emitting diode, or the like.

In the present embodiment, the formation of the drive circuit layer may include for example, the formation of a plurality of thin film transistors, a capacitor, gate lines, data lines, a power line, or the like for driving the display panel. The plurality of thin film transistors may include a drive transistor, a switch transistor, or the like; the gate lines, the data lines, the power line, or the like may extend into the peripheral area from the display area, and be electrically connected with a gate drive circuit, a data drive circuit, a power voltage terminal, or the like.

In the present embodiment, for example, the capacitor may be formed in the first area 10, the thin film transistor is formed in the second area 20, and the gate lines, the data lines, the power line may be formed in the third area 30 as part of the peripheral circuit. In the present embodiment, the power line may include one part of the source-drain conducting layer (described in detail later); for example, the power line may include a part of the gate conducting layer and a part of the source-drain conducting layer which are formed on different layers and are electrically connected with each other, and the power line may be directly or indirectly connected to the power voltage terminal.

As shown in Fig. 6, before the drive circuit layer is formed, for example, a buffer layer 1021 may be formed on the metal layer. In this way, the metal layer is located between the barrier layer 1011 and the buffer layer 1021.

In the present embodiment, for example, a layer of active layer material may be formed on the buffer layer 1021, then the active layer material is patterned by a photolithography process, and finally, the active layer 1022 for forming the thin film transistor is formed in the second area. Afterwards, the corresponding conducting process is performed on other parts of the active layer 1022 other than the channel region. In the present embodiment, the buffer layer 1021 may be made of silicon nitride, silicon oxide, silicon oxynitride, or the like; the active layer 1022 may be made of amorphous silicon, polysilicon, oxide semiconductor (for example, IGZO), or the like, and it is not limited in the present embodiment.

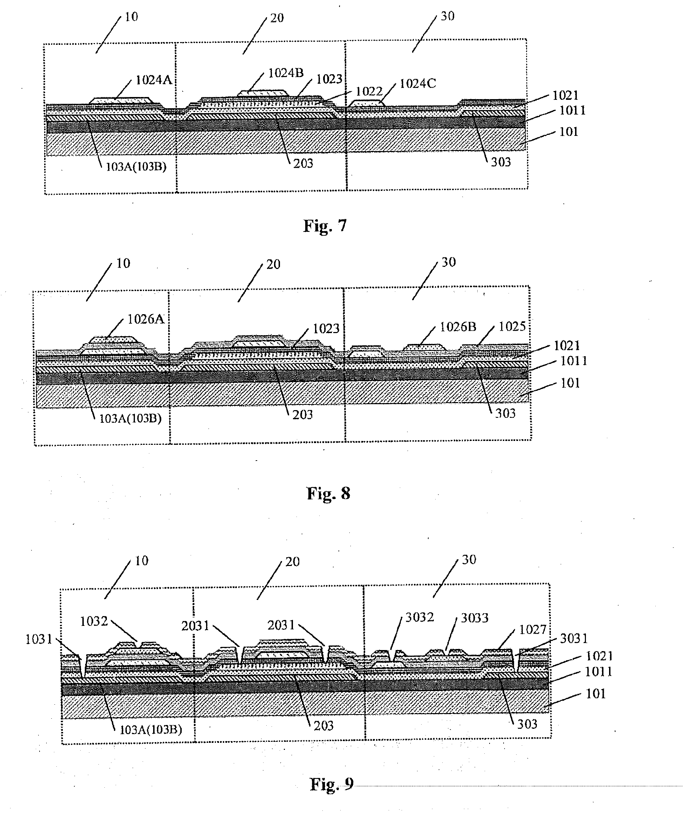

As shown in Fig. 7, after the active layer 1022 is formed, the first gate insulating layer 1023 is formed on the whole surface of the substrate. Afterwards, the first gate material layer is formed on the first gate insulating layer 1023, and then the first gate material layer is patterned by a photolithography process to form the first gate conducting layer. The first gate conducting layer may include the part 1024A located in the first area 10, the part 1024B located in the second area 20 and the part 1024C located in the third area 30. The part 1024A as described below is used for forming the capacitor, the part 1024B is used for forming the gate electrode of the thin film transistor, and the part 1024C is used for forming the signal lines.

In the present embodiment, the first gate insulating layer 1023 may be made of an appropriate material, such as silicon nitride, silicon oxide, silicon oxynitride, or the like; the first gate conducting layer may be made of a conducting material of metal, such as molybdenum, aluminum, or titanium, and is not limited in the present embodiment. In some examples of the present embodiment, for example, when the active layer is made of polysilicon, the gate conducting layer 1024B may be used as a mask, to dope the active layer 1022.

As shown in Fig. 8, after the first gate conducting layer is formed, for example, the second gate insulating layer 1025 is formed on the whole substrate. Afterwards, the second gate material layer is formed on the second gate insulating layer 1025, and then the second gate material layer is patterned by a photolithography process to form the second gate conducting layer. The second gate conducting layer may include the part 1026A located in the first area 10 and the part 1026B located in the third area 30.

For example, the part 1026A of the second gate conducting layer located in the first area 10, the second gate insulating layer 1025 and the part 1024A of the first gate conducting layer may form a first capacitor. The part 1024A of the first gate conducting layer acts as the first electrode of the first capacitor, the second gate insulating layer 1025 acts as the medium of the first capacitor, and the part 1026A of the second gate conducting layer acts as the second electrode of the first capacitor. In the present embodiment, the part 1024A of the first gate conducting layer, the buffer layer 1021, the first gate insulating layer 1023, and the second part 103B of the metal layer may further form the second capacitor, and the second electrode of the first capacitor is electrically connected with the second part 103B of the metal layer, so that the first capacitor is connected with the second capacitor in parallel. In this way, the second part 103B of the metal layer may increase the total capacitance of the capacitors of the pixel units.

In the present embodiment, the second gate insulating layer 1025 may be made of an appropriate material, such as silicon nitride, silicon oxide, silicon oxynitride, or the like; the second gate conducting layer may be made of a conducting material of metal, such as molybdenum, aluminum, or titanium, and is not limited in the present embodiment.

As shown in Fig. 9, after the second gate conducting layer is formed, an insulating layer 1027 is formed on the whole surface of the substrate. Afterwards, a plurality of via holes for exposing the metal layer, the first gate conducting layer and the second gate conducting layer are formed in a plurality of functional layers respectively by a patterning process, such as a photolithography process. For example, these via holes may include a first via hole 1031 which is located in the first area 10 and exposes the first part 103A of the metal layer, a second via hole 3031 which is located in the third area 30 and exposes the fourth part 303 of the metal layer, a third via hole 1032 which is located in the first area 10 and exposes the part 1026A of the second gate, a fourth via hole 2031 and a fifth via hole 2032 which are located in the second area 20 and exposes the active layer 1022, a sixth via hole 3032 which is located in the third area 30 and exposes the part 1024C of the first gate electrode, and a seventh via hole 3033 which is located in the third area 30 and exposes the part 1024B of the second gate; and in order to connect the conducting parts located on different layers in parallel better, more via holes may be formed at different positions. In the present embodiment, these via holes may be formed through a single patterning process. In the present embodiment, the insulating layer 207 may be made of an appropriate material, such as silicon nitride, silicon oxide, or the like and is not limited in the present embodiment.

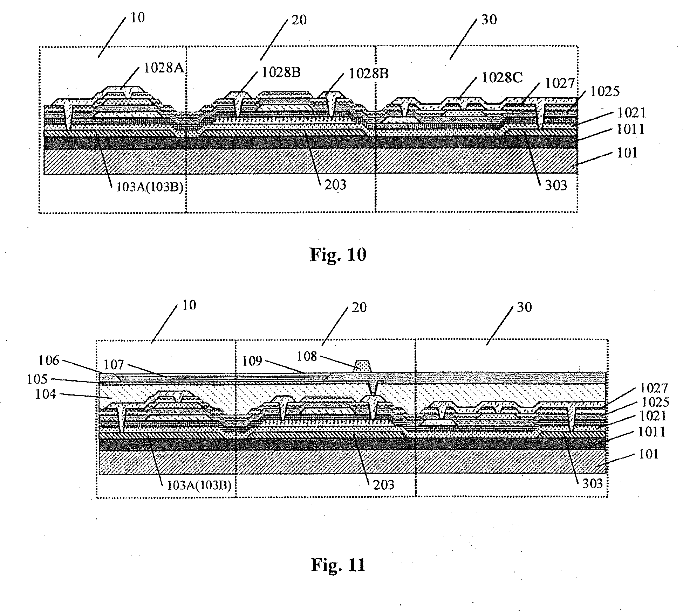

As shown in Fig. 10, after a plurality of via holes are formed, a source-drain metal layer is formed on the substrate surface, and then is patterned with a photographic process to form a patterned source-drain conducting layer 1028 which is electrically connected with the exposed metal layer, first gate conducting layer, or second gate conducting layer through the via holes.

In the present embodiment, the patterned source-drain conducting layer 1028 includes the part 1028A formed in the first area 10, the part 1028B formed in the second area 20, and the part 1028C formed in the third area 30.

In the present embodiment, the part 1028A of the source-drain conducting layer 1028 in the first area 10 may be electrically connected with the first part 103 of the metal layer and the part 1026A of the second gate conducting layer, and act as a part of the power line for providing the power voltage signal for the pixel units. In this way, the first part 103 of the metal layer may be electrically connected with the power line in parallel. The parallel connection can reduce the transfer resistance of the power voltage signal, and reduce the voltage drop generated when the power voltage signal is transferred and the difference of the power voltage signal at various positions of the display panel, as well as achieve the technical effects of improving display uniformity of the display panel.

The part 1028B of the source-drain conducting layer 1028 in the second area 20 includes two parts which are electrically connected with the active layer 1022, respectively, to form the source electrode and drain electrode of the thin film transistor. The thin film transistor may be used for driving the light emitting element (organic light emitting diode) formed afterwards.

The part 1028C of the source-drain conducting layer 1028 in the third area 30 is electrically connected with the fourth part 303 of the metal layer, the part 1024C of the first gate conducting layer, and the part 1026B of the second gate conducting layer. The resulted structure can be used for forming the power line. The resulted power line may consist of parts on three different layers, and the parts may be electrically connected with each other via at least one via hole (for example, parallel connection), the resistance of the power line may be reduced. The part 1028C of the source-drain conducting layer 1028 in the third area 30 may act as a part of the power line for providing the power voltage signal for the pixel unit. In this way, the fourth part 303 of the metal layer is electrically connected with the power line in parallel. The parallel connection can reduce the transfer resistance of the power voltage signal, and the voltage drop generated when the power voltage signal is transferred, so as to reduce the difference of the power voltage signal at various positions of the display panel, achieving the technical effects of improving display uniformity of the display panel.

In the present embodiment, the source-drain conducting layer 1028 may be made of a conducting material of metal, such as titanium, titanium alloy, aluminum, aluminum alloy, molybdenum, molybdenum alloy, copper, or copper alloy, and is not limited in the present embodiment.

As shown in Fig. 11, in the present embodiment, the method for manufacturing a display panel further includes steps of forming functional structures, such as a planarization layer 104, a pixel electrode layer 105, a pixel definition layer 106, a light-emitting layer 107 and a spacer 108 on the source-drain conducting layer 1028. In the method, a common electrode 109 for forming the light emitting element and a package structure (not shown) are also formed. The common electrode 109 and the pixel electrode layer 105 are formed with the light-emitting layer 107 sandwiched therebetween, to form an organic light-emitting diode, no description is repeated herein. The common electrode 109 is electrically connected with the other power voltage terminal, for example.

The display panel manufactured by the method according to the present embodiment includes the patterned metal layer located between the drive circuit layer and the base substrate. The metal layer may include a plurality of parts, where at least a first part may be used for connecting the power voltage signal of the display panel, so the part can reduce the transfer resistance of the power voltage signal, and reduce the voltage drop generated when the power voltage signal is transferred, and further reduce the difference in the power voltage signal at various positions of the display panel, so that the display brightness at each position of the display panel is more accurate, achieving the technical effects of improving display uniformity of the display panel. For example, for a display panel with a large size, the metal layer can effectively improve the display uniformity of the display panel.

In the present embodiment, the second part of the metal layer may be combined with the first capacitor of the display panel to form the second capacitor, so as to increase a total capacitance of the capacitors of the pixel unit. The increase in the capacitance can realize more sufficient power supply volume for each pixel unit of the display panel, which can avoid blinking display of the pixel unit, and improve the display quality of the display panel. In addition, the parallel connection of the first capacitor arid the second capacitor may increase the capacitance per unit area of the capacitor, which can reduce the space where the capacitor occupies for a given capacitance, and contribute to the design of high resolution of the display panel.

In the present embodiment, the third part of the metal layer is arranged corresponding to the thin film transistor, for effectively protecting the channel region of the thin film transistor, and avoiding harmful effects due to the external rays of light incident on the channel region. The fourth part of the metal layer is located in the peripheral area, for connecting the power voltage signal of the display panel to improve the display uniformity of the display panel, or connecting other signals, for taking full advantage of the space of the peripheral area, contributing to the design of a narrow bezel of the display panel.

In addition, in the present embodiment, various parts of the metal layer are formed in a same layer of the display panel, so these parts can be formed in s same process step. For example, these parts are formed by a single patterning process with a same mask. In addition, other insulating layers are not needed when the metal layer according to the present embodiment is formed, so the metal layer may be prepared by adding only one process step. In this way, the method according to the present embodiment may simplify the manufacture process of the display panel, and save costs.

The following points need to be noted:
(1) The accompanying drawings involve only structures in connection with the embodiments of the present disclosure, and other structure(s) can be referred to common design(s).
(2) For clarity, in the accompanying drawings of the embodiments of the present disclosure, the thickness of layers or regions is enlarged or reduced. That is, the accompanying drawings are not drawn according to actual scales. It is to be understood that, when a component or element, such as layer, film, area, substrate, or the like is referred to be "on" or "under" another component or element, it may be directly on or under the another component or element, or a component or element is interposed therebetween.
(3) Without conflict, the embodiments of the present disclosure and the features in the embodiments can be combined with each other to obtain new embodiments.

The descriptions above are only specific embodiments of the present invention, but the scope of the present disclosure is not intended to be limited thereto. Without departing the scope of the present disclosure, any modifications, and replacements easily made by a person skilled in the art shall fall within the scope of the present disclosure. The scope of the present disclosure is defined by the claims.

## Claims

1. A display panel, comprising:
a base substrate;
pixel units on the base substrate, each of the pixel units comprising a drive circuit layer;
a patterned metal layer between the drive circuit layer and the base substrate, the metal layer comprising a first part at least configured to connect the power voltage signal of the display panel.

2. The display panel according to claim 1, wherein the drive circuit layer comprises a power line configured to provide a power voltage signal for the pixel units, the first part being connected with the power line in parallel.

3. The display panel according to claim 2, wherein the power line comprises a part of the source-drain conducting layer.

4. The display panel according to any one of claims 1-3, wherein the drive circuit layer comprises a capacitor and a thin film transistor, the capacitor comprising a first electrode and a second electrode, and wherein the metal layer further comprises a second part, the first electrode being located between the second electrode and the second part, an orthographic projection of the first electrode on the base substrate being at least partially overlapped with that of the second part on the base substrate, and the second electrode being electrically connected with the second part of the metal layer.

5. The display panel according to claim 4, wherein the first part is electrically connected with the second part.

6. The display panel according to claim 4 or 5, wherein the metal layer further comprises a third part, an orthographic projection of the third electrode on the base substrate being at least partially overlapped with that of the active layer of the thin film transistor on the base substrate.

7. The display panel according to any one of claims 1-6, wherein the display panel comprises a display area and a peripheral area, wherein the first part of the metal layer is located in the display area, and the metal layer further comprises a fourth part located in the peripheral area, and configured to transfer signals.

8. The display panel according to any one of claims 1-6, wherein the display panel further comprises a barrier layer and a buffer layer between the base substrate and the drive circuit layer, the metal layer being provided between the barrier layer and the buffer layer.

9. A method for manufacturing a display panel, comprising:
forming a patterned metal layer on the base substrate; and
forming pixel units on the metal layer, each of the pixel units comprising a drive circuit layer;
wherein the metal layer comprises a first part at least configured to connect a power voltage signal of the display panel.

10. The method for manufacturing a display panel according to claim 9, wherein the drive circuit layer comprises a power line for providing a power voltage signal for the pixel units, the first part being formed to be connected with the power line in parallel.

11. The method for manufacturing a display panel according to claim 10, wherein a capacitor and a thin film transistor are formed in the drive circuit layer;
wherein the capacitor comprises a first electrode and a second electrode, the metal layer further comprising a second part, the first electrode being formed between the second electrode and the second part, an orthographic projection of the first electrode on the base substrate being at least partially overlapped with that of the second part on the base substrate, and the second electrode being formed to be electrically connected with the second part of the metal layer.

12. The method for manufacturing a display panel according to claim 11, wherein the first part is formed to be electrically connected with the second part.

13. The method for manufacturing a display panel according to claim 11, wherein the metal layer further comprises a third part, an orthographic projection of the third part on the base substrate being at least partially overlapped with that of the active layer of the thin film transistor on the base substrate.

14. The method for manufacturing a display panel according to claim 13, wherein the display panel comprises a display area and a peripheral area, the first part of the metal layer being formed in the display area, and wherein the metal layer further comprises a fourth part formed in the peripheral area, the fourth part being used for transferring signals.

15. The method for manufacturing a display panel according to any one of claims 9-13, further comprising forming a barrier layer and a buffer layer between the base substrate and the drive circuit layer, wherein the metal layer is formed between the barrier layer and the buffer layer.

16. The method for manufacturing a display panel according to claim 14, wherein a first via hole is formed in at least the drive circuit layer on the first part, to allow the first part to be connected with the power line through the first via hole.

17. The method for manufacturing a display panel according to claim 16, wherein a second via hole is formed in at least the drive circuit layer on the fourth part, to allow the fourth part to be connected with the power line through the second via hole.

18. The method for manufacturing a display panel according to claim 17, wherein the first via hole and the second via hole are formed by a same mask.

19. The method for manufacturing a display panel according to claim 14, wherein the first part, the second part, the third part and the fourth part are formed by a same mask.

20. A display device, comprising the display panel according to any one of claims 1-8.
